# FASCICULE DE BREVET EUROPEEN

(11) **EP 3 732 744 B1**
(45) Date de publication et mention de la délivrance du brevet: **08.03.2023**
(21) Numéro de dépôt: 19710032.4
(22) Date de dépôt: 05.02.2019
(51) Int. Cl.: H01M 10/6568, H01M 10/61

(54) **DISPOSITIF DE REGULATION DE TEMPERATURE D'UNE BATTERIE OU D'UN DISPOSITIF ELECTRONIQUE DE PUISSANCE .**
GERÄT FÜR DIE TEMPERATURKONTROLLE EINER BATTERIE BZW. EINES ELEKTRONISCHEN KRAFTGERÄT.
TEMPERATURE CONTROL DEVICE FOR A BATTERY OR AN ELECTRONICAL POWER DEVICE

(30) Priorité: 05.02.2018 FR 1850947
(43) Date de publication de la demande: 04.11.2020
(73) Titulaire: Valeo Systemes Thermiques-THS, 78322 Le Mesnil Saint Denis Cedex (FR)
(72) Inventeur: AZZOUZ, Kamel, 78322 LE MESNIL SAINT DENIS CEDEX (FR); MAMMERI, Amrid, 78322 LE MESNIL SAINT DENIS CEDEX (FR)
(74) Mandataire: Valeo Systèmes Thermiques
(86) Numéro de dépôt international: PCT/FR2019/050260
(87) Numéro de publication internationale: WO 2019/150061

(56) Documents cités:
- CN-U- 202 329 208
- US-A1- 2002 113 142
- US-A1- 2002 172 007
- US-A1- 2004 123 975
- US-B2- 6 889 515
- US-B2- 7 082 778
- US-B2- 7 134 289
- Jeremy Scott Junghans: "Development of Spray Cooling for High Heat Flux Electronics", , 31 décembre 2011 (2011-12-31), pages 1-79, XP055592539, Extrait de l'Internet: URL:https://pdfs.semanticscholar.org/cc16/ a43b51350a7af3cf554fcbb1862a92459277.pdf [extrait le 2019-05-28]
- MUDAWAR I ET AL: "Two-Phase Spray Cooling of Hybrid Vehicle Electronics", IEEE TRANSACTIONS ON COMPONENTS AND PACKAGING TECHNOLOGIES,, vol. 32, no. 2, 1 juin 2009 (2009-06-01), pages 501-512, XP011346895, ISSN: 1521-3331, DOI: 10.1109/TCAPT.2008.2006907
- Desikan Bharathan ET AL: "Spray cooling: An assessment for use with automotive power electronics applications Prepared by", , 30 September 2005 (2005-09-30), XP055592544, Retrieved from the Internet: URL:https://www.nrel.gov/transportation/as sets/pdfs/spray_cooling_milestone.pdf
- Desikan Bharathan ET AL: "Spray cooling: An assessment for use with automotive power electronics applications Prepared by", , 30 September 2005 (2005-09-30), XP055592545, Retrieved from the Internet: URL:https://www.nrel.gov/transportation/as sets/pdfs/spray_cooling_milestone.pdf [retrieved on 2019-05-28]

## Description

L'invention concerne un dispositif de régulation de température de cellules de batterie à l'aide d'un fluide diélectrique. L'invention concerne également un pack batterie comprenant ledit dispositif ainsi qu'une pluralité de cellules de batterie. Elle est en particulier destinée à équiper des véhicules automobiles, en particulier des véhicules automobiles à motorisation électrique ou hybride.

La part de marché des véhicules électriques étant de plus en plus importantes, les problématiques de refroidissement/chauffage des packs batterie qui les équipent deviennent des enjeux stratégiques. L'objectif est de concevoir un dispositif de gestion thermique des batteries le plus performant, efficient et économique possible.

Souvent pour répondre au besoin de refroidissement/chauffage des batteries électriques, on utilise des « échangeurs de chaleurs» consistants en une plaque froide avec circulation d'un liquide de refroidissement, les plaques étant au contact des cellules à refroidir. Ce genre de techniques conduit à un refroidissement non homogène des batteries et limite ainsi leur durée de vie et leur performance. Ces dispositifs présentent en outre une résistance thermique élevée en raison des épaisseurs de matière présentes entre le liquide de refroidissement et les cellules.

Une solution proposée pour répondre à cette problématique consiste en une immersion des batteries électriques dans un fluide caloporteur diélectrique. Cette immersion peut être réalisée avec une circulation de fluide ou en condition statique avec changement de phase.

Ces deux techniques sont performantes d'un point de vue thermique en particulier en raison du contact direct établi entre le liquide et les cellules mais présentent le désavantage d'utiliser une grande quantité de liquide diélectrique, ce qui augmente le coût et le poids du pack batterie.

Le document "Two-Phase Spray Cooling of Hybrid Vehicle Electronics",IEEE TRANSACTIONS ON COMPONENTS AND PACKAGING TECHNOLOGIES,, vol. 32, no. 2, 1 juin 2009 (2009-06-01), pages 501-512, XP011346895,ISSN: 1521-3331, DOI: 10.1109/TCAPT.2008.2006907f dont l'auteur est MUDAWAR I ET AL décrit des systèmes de réfrigération des batteries automobile.

L'invention vise à résoudre ces problèmes techniques en proposant un dispositif de régulation de température d'un composant électrique susceptible de dégager de la chaleur lors de son fonctionnement, ledit composant étant un élément de stockage d'énergie électrique de type batterie comprenant au moins une cellule.

Les caractéristiques essentielles de l'invention sont explicitement décrites dans la revendication de dispositif 1 et dans la revendication indépendante de pack-batterie 11. Le libellé de la revendication 1 concerne textuellement D un dispositif (1) de régulation de température d'une batterie comprenant au moins une cellule (100) de stockage d'énergie, ledit dispositif (1) comprenant un circuit (10) de fluide diélectrique, ledit circuit (10) comprenant des moyens (12) pour arroser la surface de ladite cellule (100) à l'aide dudit fluide diélectrique (3), le fluide étant destiné à se vaporiser au moins en partie à la surface des cellules, dans lequel les moyens (12) pour arroser comprennent des buses d'aspersion (14) du fluide diélectrique (3) en phase liquide, le dispositif étant caractérisé en ce qu'il comprend un réservoir (16) configuré pour être dispose sous les cellules (100) et apte à récupérer, sous phase liquide, le fluide diélectrique (3) envoyé à la surface des cellules (100) de batterie ainsi qu'une pompe (18) configurée pour aspirer ledit fluide diélectrique (3) dans le réservoir (16) et le mettre sous pression dans ledit circuit (10) de fluide diélectrique et en ce qu'il comprend en outre au moins un moyen de refroidissement (20) du fluide diélectrique (3) ledit moyen comprenant un condenseur (26) configuré de sorte à condenser le fluide diélectrique (3) pour passer de phase vapeur en phase liquide et à faire ruisseler ledit fluide (3) jusqu'au réservoir (16).

Par moyen pour arroser on entend tout type de moyen permettant de mettre en contact le fluide diélectrique avec la ou les surfaces des cellules de batteries autrement qu'en immergeant lesdites cellules dans ledit fluide diélectrique.

Il s'agit en particulier de moyen d'aspersion, de moyen de projection ou de tous moyens aptes à produire une circulation dudit fluide de sorte à mettre au contact le fluide diélectrique avec la surface des cellules, sous la forme d'un film de fluide, de jets, de gouttelettes d'une brumisation ou autre.

Ce dispositif permet non seulement de récupérer de grande quantité de chaleur et d'assurer un refroidissement homogène par contact direct du fluide diélectrique et des cellules à refroidir mais permet également de limiter la quantité de fluide diélectrique et donc le poids du dispositif en éliminant le bain de liquide diélectrique connu dans les dispositifs précédents.

D'autres caractéristiques techniques de l'invention sont définies explicitement dans les libellés des revendications dépendantes 2 à 10. U

L'invention peut en plus comprendre l'une quelconque des caractéristiques suivantes, prises individuellement ou selon toute combinaison techniquement possible :
- les buses d'aspersion sont configurées pour être placées entre chaque cellule de batterie de sorte à projeter le fluide diélectrique sur des faces latérales des cellules,
- les buses d'aspersion sont configurées pour être placées au-dessus de chaque cellule de batterie de sorte à projeter le fluide diélectrique sur des faces supérieures des cellules,
- les buses d'aspersion sont configurées de sorte à produire un jet de fluide diélectrique,
- les buses d'aspersion sont configurées de sorte à pulvériser le fluide diélectrique sous forme de fines gouttes, destinées à s'écouler à la surface des cellules,
- le dispositif comprend au moins un moyen de refroidissement du fluide diélectrique,
- le moyen de refroidissement du fluide diélectrique comprend un échangeur de chaleur situé dans le circuit de fluide diélectrique,
- le moyen de refroidissement du fluide diélectrique comprend un échangeur de chaleur situé dans le réservoir,
- le condenseur est positionné au-dessus des cellules de batterie, préférentiellement le condenseur recouvre une majorité de la surface occupée par les cellules,
- le condenseur est configuré pour la circulation d'un fluide réfrigérant destiné à échanger de la chaleur avec le fluide diélectrique,
- le moyen de refroidissement comprend un échangeur de chaleur permettant un échange de chaleur entre un fluide réfrigérant et un fluide de refroidissement,
- le condenseur est configuré pour la circulation dudit fluide de refroidissement en vue d'échanger de la chaleur avec le fluide diélectrique,
- le dispositif comprend un moyen de chauffage dudit liquide diélectrique,
- le moyen de chauffage est situé dans le réservoir,
- les moyens pour arroser comprennent des tubes,
- chaque tube est configuré pour orienter le fluide vers au moins deux des cellules de batterie,
- les tubes comprennent au moins trois buses d'aspersion, configurées pour être orientées vers l'une au moins des cellules,
- le dispositif est configuré pour qu'au moins trois desdits tubes soient disposés en regard de chaque face latérale des cellules de batterie,
- les moyens pour arroser comprennent des plaques, chaque plaque présentant deux faces latérales orientées vers les cellules de batterie,
- les plaques comprennent au moins neuf buses d'aspersion sur chacune de leurs faces latérales,
- le dispositif est configuré pour qu'au moins une plaque soit disposée en regard de chaque face latérale des cellules de batterie,
- les buses d'aspersion présentent une partie interne cylindrique et une partie externe conique divergente à partir de la partie interne,
- les moyens pour arroser comprennent des pattes destinées à venir en appuis sur les cellules et permettant le maintien en position desdits moyens au sein du dispositif
- les moyens pour arroser sont configurés de sorte à résister à des pressions supérieures à 10 bars,
- le fluide diélectrique possède la capacité de changer d'état ou de phase en fonction de la température, avantageusement le point de changement d'état est choisi en fonction de la température optimale de fonctionnement du dispositif électrique à réguler thermiquement.
- le fluide diélectrique évolue dans une enceinte fermée, hermétique audit fluide indépendamment de son état.
- l'enceinte fermée est délimitée par les parois du pack batterie,
- le condenseur est positionné au-dessus d'une paroi supérieure du pack batterie,
- le condenseur forme une paroi supérieure du pack batterie,
- le condenseur recouvre ou surplombe une majorité, préférentiellement l'intégralité de la zone comprenant les cellules de batterie.
- le condenseur présente une face sensiblement plane et inclinée par rapport à une direction horizontale lorsque le pack batterie est monté sur un véhicule automobile,

L'invention concerne également un pack batterie, ou boitier comprenant le dispositif décrit plus haut ainsi qu'une pluralité de cellules de batteries.

L'invention sera mieux comprise et d'autres détails, caractéristiques et avantages de l'invention apparaîtront à la lecture de la description suivante faite à titre d'exemple non limitatif et en référence aux dessins annexés dans lesquels :
- la figure 1, illustre de façon schématique en vue de coupe un premier mode de réalisation d'un dispositif selon l'invention,
- la figure 2, illustre de façon schématique en vue de coupe un deuxième mode de réalisation d'un dispositif selon l'invention,
- la figure 3, illustre de façon schématique en vue de coupe un troisième mode de réalisation d'un dispositif selon l'invention,
- la figure 4, illustre de façon schématique en vue de coupe un quatrième mode de réalisation d'un dispositif selon l'invention,
- la figure 5, illustre de façon schématique en vue de coupe un cinquième mode de réalisation d'un dispositif selon l'invention,
- la figure 6, est une vue en perspective partiellement écorchée d'un premier mode de réalisation d'un pack-batterie selon l'invention,
- la figure 7, illustre de façon schématique un mode de réalisation de moyens pour arroser selon l'invention,
- la figure 8, illustre de façon schématique un autre mode de réalisation de moyens pour arroser selon l'invention,
- la figure 9, illustre de façon schématique en vue en coupe un mode de réalisation d'une buse d'aspersion selon l'invention,
- la figure 10, est une vue en perspective d'un mode de réalisation d'un dispositif selon l'invention
- la figure 11, est une vue en perspective partiellement écorchée d'un deuxième mode de réalisation d'un pack-batterie selon l'invention,
- la figure 12, est une vue en perspective partiellement écorchée d'un troisième mode de réalisation d'un pack-batterie selon l'invention.

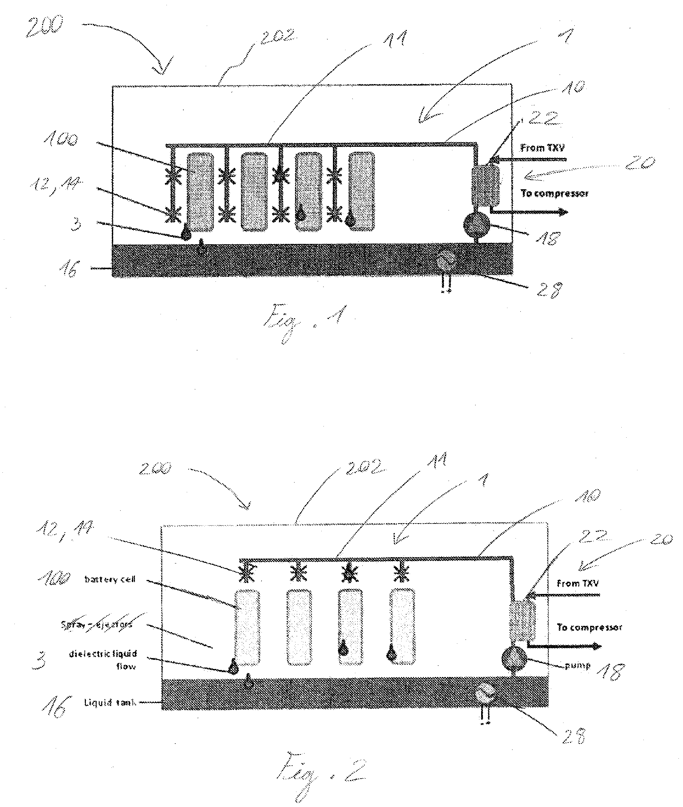

Comme illustré à la figure 1, l'invention concerne un dispositif 1 de régulation de la température d'une batterie. Ladite batterie comprend au moins une cellule 100 de stockage d'énergie. Il s'agit notamment d'une batterie de véhicule électrique. La batterie comprend ici quatre cellules 100 mais il s'agit uniquement d'un exemple schématique et la batterie pourra comprendre un bien plus grand nombre de cellules.

Pour leur bon fonctionnement, il est souhaité que la température des batteries soit maintenue dans un intervalle de valeur restreint, notamment entre 20 et 40°C. Le dispositif conforme à l'invention a précisément pour fonction d'effectuer une telle régulation de température.

Ledit dispositif 1 comprend un circuit 10 de fluide diélectrique ainsi que des moyens 12 pour arroser la surface de la cellule 100 à l'aide dudit fluide diélectrique 3. Le circuit 10 de fluide diélectrique peut être formé par une pluralité de canaux ou rampes d'alimentation 11 en fluide diélectrique 3 alimentant les moyens 12 pour arroser.

Ledit circuit 10 est un circuit fermé dans lequel le fluide diélectrique est amené à changer de phase, ou non, ceci en fonction des différents modes de réalisation développés dans la suite.

Les moyens 12 permettent de réguler efficacement la température des cellules 100 de batterie en les arrosant tout en limitant la quantité de fluide diélectrique 3 utilisé. En effet, le dispositif 1 selon l'invention nécessite une quantité de fluide 3 bien moindre que dans un dispositif dans lequel les cellules sont immergées dans un fluide diélectrique.

Avantageusement, les moyens 12 pour arroser comprennent des buses d'aspersion 14 du fluide diélectrique, en phase liquide. Lesdites buses d'aspersion 14 permettent d'asperger du fluide 3 en direction de l'une quelconque des surface de la ou des cellules 100 de batterie. L'aspersion du fluide 3 par les buses 14 peut être monodirectionnelle ou poly directionnelle.

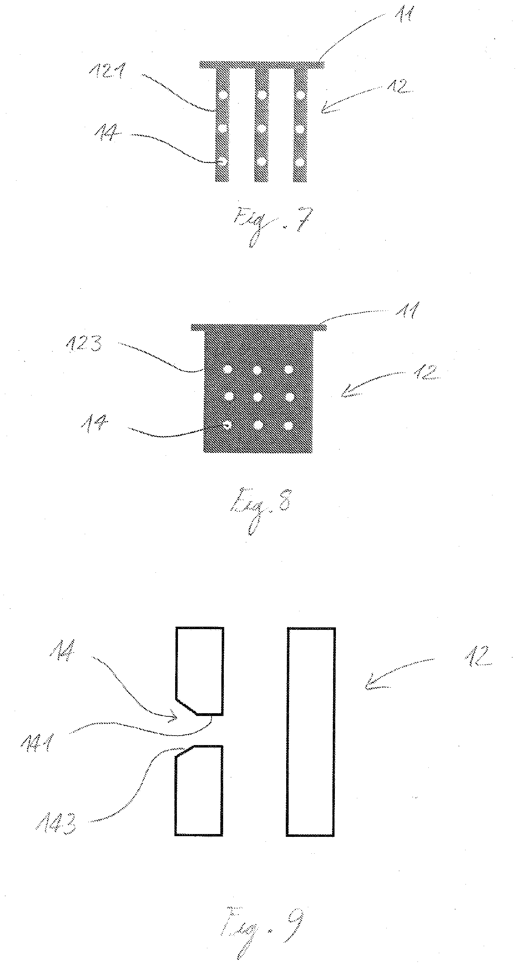

Selon un mode de réalisation représenté à la figure 9, les buses d'aspersion 14 présentent une partie interne 141 cylindrique et une partie externe 143 conique divergente à partir de la partie interne. La forme et les dimensions de la buse permettent notamment de contrôler la forme de l'aspersion. Le diamètre de la buse peut être compris entre 50 et 500 µm. Préférentiellement, les buses d'aspersion 14 sont formées dans l'épaisseur des tubes 121 ou des plaques 123.

Selon un mode de réalisation représenté à la figure 1, les buses d'aspersion 14 sont configurées pour être placées entre chaque cellule 100 de batterie de sorte à projeter le fluide diélectrique 3 sur des faces latérales des cellules 100. Cette disposition des buses d'aspersion 14 permet de couvrir une surface maximale de cellules 100 et ainsi d'optimiser la régulation de la température.

Selon un autre mode de réalisation représenté à la figure 2, les buses d'aspersion 14 sont configurées pour être placées au-dessus de chaque cellule 100 de batterie de sorte à projeter le fluide diélectrique 3 sur des faces supérieures des cellules 100. Il a été observé par la demanderesse que les zones des cellules 100 subissant les plus importantes montées en température lors de l'utilisation de la batterie sont les zones supérieures, au niveau des connexions électriques. Cette disposition des buses d'aspersion 14 permet ainsi de cibler plus précisément les zones de températures élevées et donc d'optimiser la régulation de la température.

Selon un mode de réalisation, lesdites buses d'aspersion 14 sont configurées de sorte à produire un jet 5 de fluide diélectrique 3, en phase liquide.

Le jet 5 de fluide diélectrique 3 peut être de puissance variable. Ledit fluide 3 peut ainsi venir percuter la surface de la cellule 100. Ledit fluide 3 peut alternativement venir ruisseler le long de la surface de ladite cellule 100 sans impact. Le jet 5 peut être monodirectionnelle ou poly directionnelle.

Selon un autre mode de réalisation, les buses d'aspersion 14 sont configurées de sorte à pulvériser le liquide diélectrique 3 sous forme de fines gouttes 7. La taille des gouttes 7 peut être variable. Les buses d'aspersion peuvent notamment être configurées de sorte à réaliser une brumisation du fluide 3. La pulvérisation du fluide 3 peut être monodirectionnelle ou poly directionnelle.

Le jet 5 et les gouttes 7 de fluide diélectrique ne sont pas représentés sur les figures.

Selon un mode de réalisation représenté à la figure 7, les moyens 12 pour arroser comprennent des tubes 121.

Avantageusement, lesdits tubes sont configurés de sorte à résister à des pressions supérieures à 10 bars.

Lesdits tubes peuvent avoir des dimensions variables en fonction des cellules de batterie. Les tubes peuvent par exemple présenter une hauteur comprise entre 90 et 130 mm, une largeur comprise entre 15 et 25 mm et une épaisseur comprise entre 2 et 4 mm.

Les tubes 121 permettent notamment un gain de matière et de poids au sein du dispositif.

Les tubes 121 sont avantageusement configurées pour être placées entre chaque cellule 100 de batterie de sorte à projeter le fluide diélectrique 3 sur des faces latérales des cellules 100. Ainsi, lesdits tubes 121 sont configurés de sorte à orienter le fluide 3 vers au moins deux des cellules 100 de batterie.

Avantageusement, les tubes 121 comprennent au moins trois buses d'aspersion 14. Les buses d'aspersion 14 sont configurées pour être orientées vers l'une au moins des cellules.

Le nombre de tube 121 destiné à arroser une même cellule peut varier en fonction des cellules de batterie. Avantageusement, le dispositif 1 est configuré pour qu'au moins trois tubes 121 soient disposés en regard de chaque face latérale des cellules 100 de batterie.

Selon un mode de réalisation représenté à la figure 8, les moyens 12 pour arroser comprennent des plaques 123. Chaque plaque présente deux faces latérales orientées vers les cellules 100 de batterie.

Avantageusement, lesdites plaques 123 sont configurées de sorte à résister à des pressions supérieures à 10 bars.

Lesdites plaques 132 peuvent avoir des dimensions variables en fonction des cellules de batterie.

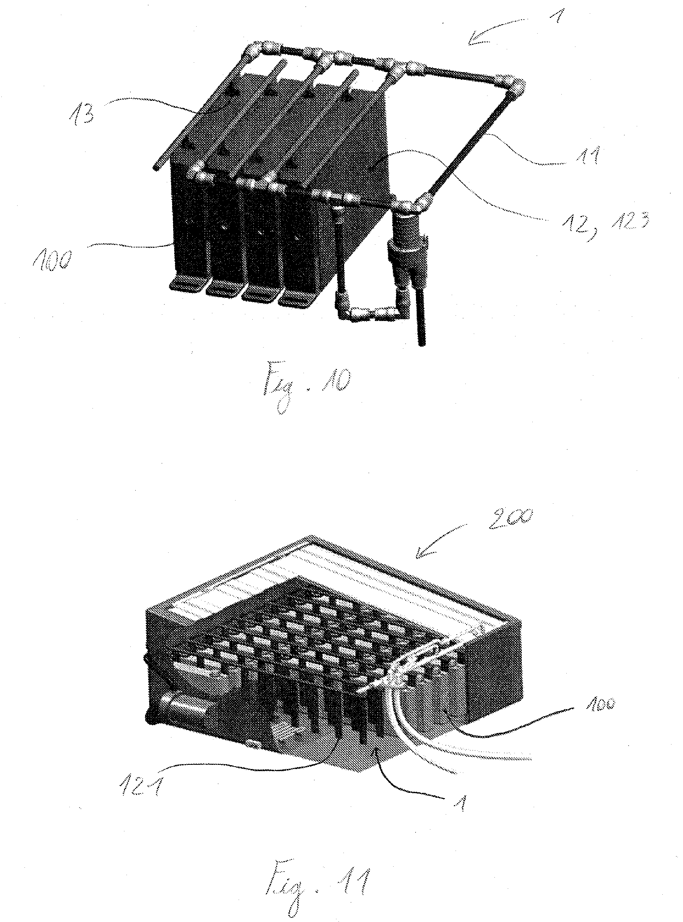

Les plaques 123 sont avantageusement configurées pour être placées entre chaque cellule 100 de batterie de sorte à projeter le fluide diélectrique 3 sur des faces latérales des cellules 100. On visualise mieux cet agencement des plaques 123 au sein du dispositif 1 à la figure 10.

Lesdites plaques 123 peuvent être configurées de sorte à orienter le fluide 3 vers au moins deux des cellules 100 de batterie.

Avantageusement, les plaques 123 comprennent au moins neuf buses d'aspersion 14 sur chacune de leurs faces latérales. Les buses d'aspersion 14 sont configurées pour être orientées vers l'une au moins des cellules.

Le nombre de plaque 123 destiné à arroser une même cellule 100 peut varier en fonction des cellules de batterie. Avantageusement, le dispositif 1 est configuré pour qu'au moins une plaque 123 soit disposée en regard de chaque face latérale des cellules 100 de batterie.

Les plaque 123 permettent notamment une meilleur densité de buses d'aspersion 14.

Selon un mode de réalisation représenté à la figure 10, les moyens 12 pour arroser comprennent des pattes 13 destinées à venir en appuis sur les cellules 100. Lesdites pattes 13 permettent le maintien en position desdits moyens 12 au sein du dispositif 1.

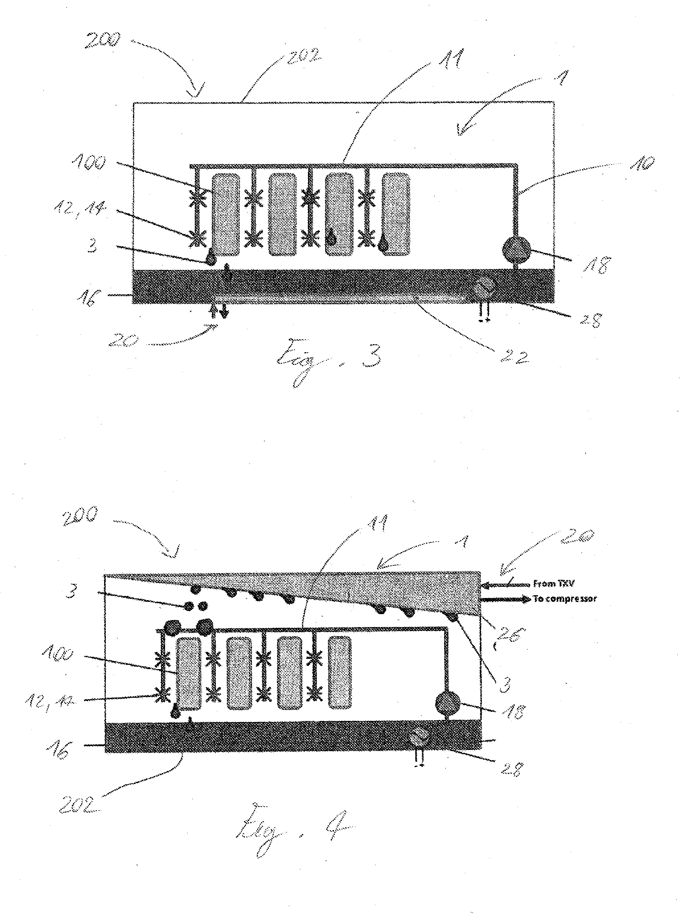

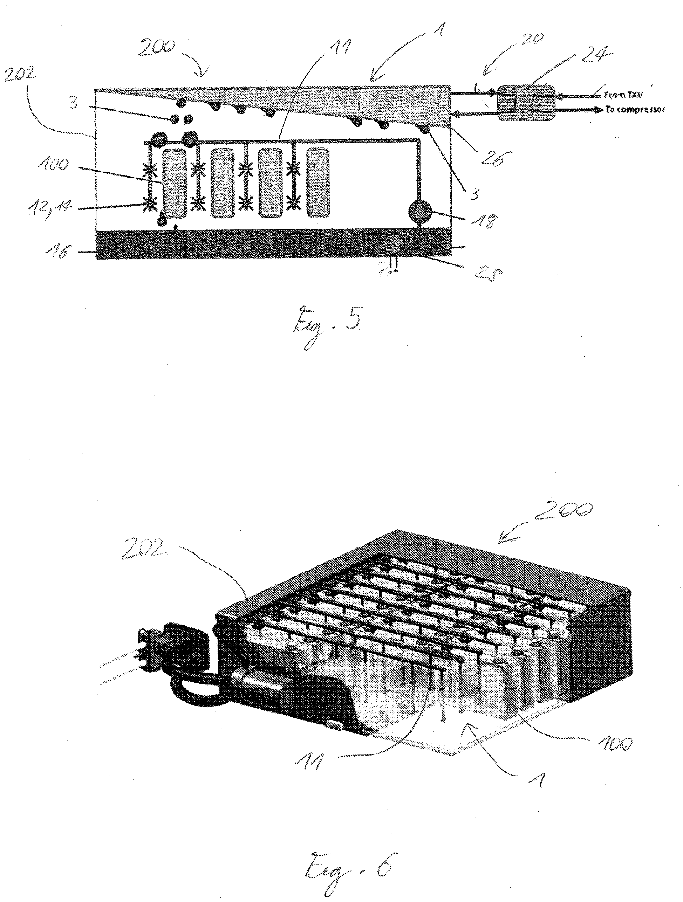

En cours d'utilisation de la batterie, les cellules 100 présentent une température supérieure à la température du fluide 3. Ledit fluide 3 peut ainsi être destiné à se vaporiser au moins en partie à la surface des cellules 100 (figures 4 et 5 en particulier).

Le dispositif 1 peut également comprendre un réservoir 16 complétant le circuit 10 et configuré pour être disposé sous les cellules 100. Ledit réservoir 16 est apte à récupérer le liquide diélectrique 3 envoyé à la surface des cellules 100 de batterie.

Le dispositif 1 peut également comprendre une pompe 18 configurée pour aspirer ledit fluide diélectrique 3 dans le réservoir 16 et le mettre sous pression dans ledit circuit 10 de fluide diélectrique.

Avantageusement, ladite pompe est configurée pour mettre le fluide sous une pression supérieure à 10 bars. Ainsi, il n'y a pas de perte de pression au sein du circuit 10 et chaque buse d'aspersion 14 est soumise à une même pression.

Une fois le fluide 3 arrosé à la surface des cellules 100, ledit fluide ruisselle jusqu'au réservoir 16. Le fluide 3 ainsi récupéré par le réservoir 16 est alors aspiré par une pompe 18 puis remis sous pressions en aval dans le circuit 10.

Ainsi, le fluide diélectrique 3 se trouve successivement sous pression puis à la pression d'un logement 202 accueillant les cellules 100 le long du circuit 10. Ici, il est à la pression du logement 202 au contact des cellules 100 puis dans le réservoir 18 avant d'être à nouveau sous pression sous l'action de la pompe 18 dans la ou les rampes 11 et les buses d'aspersion 14. Le fluide diélectrique 3 est alors constamment réutilisé. Il est ainsi possible d'utiliser une faible quantité de fluide diélectrique 3, en particulier comparé aux dispositifs dans lesquels les cellules sont immergées dans le liquide diélectrique.

Avantageusement, le dispositif 1 comprend au moins un moyen de refroidissement 20 du fluide diélectrique 3. Lorsque le fluide 3 entre au contact d'une cellule 100, ledit fluide récupère la chaleur dissipée par la cellule de batterie. Le fluide 3 est alors refroidi par ledit moyen de refroidissement 20 avant d'être à nouveau mis au contact avec la surface des cellules 100. Le fluide 3 subit ainsi un cycle de changement d'état et/ou de montée et de descente en température.

Selon un mode de réalisation représenté à la figure 1, le moyen de refroidissement 20 comprend un échangeur de chaleur 22 situé dans le circuit 10 de fluide diélectrique ici en aval de la pompe 18. Ainsi, après voir subit une montée en température suite au contact avec une cellule 100 le fluide 3 est récupéré par le réservoir 16, aspiré par la pompe 18 puis il subit une descente en température sous l'action de l'échangeur de chaleur 22. Le fluide 3 est alors transporté dans le circuit jusqu'aux buses d'aspersions, entre à nouveau au contact des cellules 100 et subit à nouveau une montée en température.

Selon un mode de réalisation représenté en figure 3, le moyen de refroidissement 20 du fluide diélectrique 3 comprend un échangeur de chaleur 22 situé dans le réservoir. Le refroidissement du fluide diélectrique 3 est ici réalisé en amont de la pompe 18. Il est ensuite aspiré par la pompe 18. Cette disposition permet d'utiliser un échangeur de chaleur 22 sous la forme d'une plaque qui peut avoir une surface d'échange de chaleur de dimensions plus importantes que dans le cas d'un échangeur de chaleur situé en aval de la pompe 18. Ainsi, l'échange de température entre le fluide diélectrique 3 et l'échangeur de chaleur 22 est amélioré.

Selon un mode de réalisation représenté à la figure 4, le fluide diélectrique 3 subit un changement de phase et se vaporise, au moins partiellement, lorsqu'il entre en contact avec la surfaces de cellules 100. Le moyen de refroidissement 20 selon ce mode de réalisation comprend un condenseur 26 configuré de sorte à condenser le fluide diélectrique 3 pour passer de phase vapeur en phase liquide et à faire ruisseler ledit fluide 3 jusqu'au réservoir 16 notamment grâce à un plan incliné. Le fluide 3 en phase liquide dans le réservoir 16 est alors aspiré par la pompe 18. Le condenseur 26 permet de condenser le fluide diélectrique 3 grâce à une différence de température entre le condenseur et le fluide diélectrique en phase vapeur.

Avantageusement, le condenseur 26 est configuré pour la circulation d'un fluide réfrigérant destiné à échanger de la chaleur avec le fluide diélectrique 3. Le réfrigérant provient d'un détendeur et circule dans le condenseur 26 de manière à abaisser la température du condenseur. Le condenseur 26 permet alors de condenser le fluide diélectrique 3 gazeux.

Selon un mode de réalisation représenté à la figure 5, le moyen de refroidissement 20 comprend en outre un échangeur de chaleur 24 permettant un échange de chaleur entre un fluide réfrigérant et un fluide de refroidissement. Le condenseur 26 selon ce mode de réalisation est configuré pour la circulation du fluide de refroidissement en vue d'échanger de la chaleur avec le fluide diélectrique 3 en phase vapeur.

Lorsque les cellules présentent une température trop faible il peut être avantageux d'augmenter leur température. Lors d'une utilisation d'une batterie dans des conditions de température faibles, par exemple inférieur à 0°C, il est avantageux de pouvoir augmenter la température des cellules 100 de batterie afin d'obtenir plus rapidement des performances optimales.

Ainsi, le dispositif 1 selon la présente invention peut comprendre un moyen de chauffage 28 du fluide diélectrique 3. Le moyen de chauffage 28 permet alors de chauffer le fluide 3 qui va à son tour chauffer les cellules 100 jusqu'à une température optimale d'utilisation. Ledit moyen de chauffage 28 peut notamment être une résistance.

Comme illustré sur les figures 1 à 5, le moyen de chauffage 28 du fluide diélectrique 3 est ici situé dans le circuit 10, avantageusement situé dans le réservoir 16.

La présente invention concerne également un pack-batterie 200 comprenant un dispositif 1 décrit plus haut ainsi qu'une pluralité de cellules 100 de batteries.

A la figure 6, on visualise mieux la pluralité de cellules 100 et la pluralité de rampe 11 d'alimentation du pack. Les rampes sont ici situées en parallèle.

Un module comprend une pluralité de cellules 100 de batterie. Les différentes cellules d'un même module peuvent par exemple être agencées côtes à côtes. Une batterie comprend une pluralité de modules. Selon un autre mode de réalisation, les rampes 11 d'alimentation peuvent alternativement être réparties d'un côté puis de l'autre côté de chaque module de cellules de batterie. Cette répartition alternée des rampes 11 d'alimentation est également visible à la figure 10.

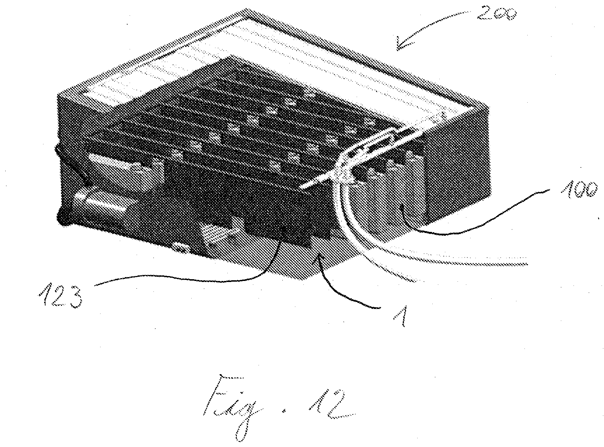

Les figures 11 et 12 représentent d'autres modes de réalisation d'un pack-batterie selon l'invention, particulièrement des modes de réalisation particulier d'un pack batterie selon le quatrième mode de réalisation de l'invention présenté en figure 4.

Dans ces modes de réalisation, le fluide diélectrique (3) évolue dans une enceinte fermée, hermétique audit fluide indépendamment de son état. Autrement dit, le fluide diélectrique est isolé à l'intérieur du pack batterie 200 par les parois du pack batterie. Le moyen de refroidissement 20 comprend un condenseur 26 avantageusement positionné au-dessus, ou formant, une paroi supérieure du pack batterie 200. Ainsi, le fluide diélectrique 3 est pulvérisé par les buses 14 sur la surface des cellules 100 et subit, au moins partiellement un changement de phase et se vaporise. La partie de fluide sous forme de vapeur se refroidit et condense une fois en contact thermique avec la paroi du condenseur et ainsi retrouve au moins partiellement un état au moins liquide. Avantageusement, le condenseur présente une face sensiblement plane et inclinée par rapport à une direction horizontale lorsque le pack batterie est monté sur un véhicule automobile, de façon à faciliter et contrôler l'écoulement du fluide le long dudit condenseur.

Selon le mode de réalisation représenté à la figure 11, les moyens 12 pour arroser sont des tubes 121. Dans le dispositif 1 du pack-batterie 200 selon ce mode de réalisation, trois tubes sont disposés en regard de chaque face latérale des cellules 100 de batterie.

Selon le mode de réalisation représenté à la figure 12, les moyens 12 pour arroser sont des plaques 123. Dans le dispositif 1 du pack-batterie 200 selon ce mode de réalisation, une plaque est disposée en regard de chaque face latérale des cellules 100 de batterie.

Bien entendu, l'invention n'est pas limitée à des modes de réalisation décrits et représentés aux dessins annexés. Des modifications restent possibles, notamment du point de vue de la constitution des divers éléments.

## Revendications

1. Dispositif (1) de régulation de température d'une batterie comprenant au moins une cellule (100) de stockage d'énergie, ledit dispositif (1) comprenant un circuit (10) de fluide diélectrique, ledit circuit (10) comprenant des moyens (12) pour arroser la surface de ladite cellule (100) à l'aide dudit fluide diélectrique (3), le fluide étant destiné à se vaporiser au moins en partie à la surface des cellules, dans lequel les moyens (12) pour arroser comprennent des buses d'aspersion (14) du fluide diélectrique (3) en phase liquide,
le dispositif étant **caractérisé en ce qu'**il comprend un réservoir (16) configuré pour être disposé sous les cellules (100) et apte à récupérer, sous phase liquide, le fluide diélectrique (3) envoyé à la surface des cellules (100) de batterie ainsi qu'une pompe (18) configurée pour aspirer ledit fluide diélectrique (3) dans le réservoir (16) et le mettre sous pression dans ledit circuit (10) de fluide diélectrique et **en ce qu'**il comprend en outre au moins un moyen de refroidissement (20) du fluide diélectrique (3) ledit moyen comprenant un condenseur (26) configuré de sorte à condenser le fluide diélectrique (3) pour passer de phase vapeur en phase liquide et à faire ruisseler ledit fluide (3) jusqu'au réservoir (16).

2. Dispositif (1) selon la revendication 1, **caractérisé en ce que** les buses d'aspersion (14) sont configurées pour être placées entre chaque cellule (100) de batterie de sorte à projeter le fluide diélectrique (3) sur des faces latérales des cellules (100).

3. Dispositif (1) selon la revendication 1, **caractérisé en ce que** les buses d'aspersion (14) sont configurées pour être placées au-dessus de chaque cellule (100) de batterie de sorte à projeter le fluide diélectrique (3) sur des faces supérieures des cellules (100).

4. Dispositif (1) selon l'une des revendications 1 à 3, **caractérisé en ce que** les buses d'aspersion (14) sont configurées de sorte à produire un jet (5) de fluide diélectrique (3), ledit fluide (3) étant destiné à se vaporiser au moins en partie à la surface des cellules (100).

5. Dispositif (1) selon l'une des revendications 1 à 3, **caractérisé en ce que** les buses d'aspersion (14) sont configurées de sorte à pulvériser le fluide diélectrique (3) sous forme de fines gouttes (7), destinées à s'écouler à la surface des cellules (100).

6. Dispositif (1) selon la revendication 1, **caractérisé en ce que** le moyen de refroidissement (20) du fluide diélectrique (3) comprend un échangeur de chaleur (22) situé dans le circuit (10) de fluide diélectrique.

7. Dispositif (1) selon la revendication 1, **caractérisé en ce que** le moyen de refroidissement (20) du fluide diélectrique (3) comprend un échangeur de chaleur (22) situé dans le réservoir (16).

8. Dispositif (1) selon la revendication 1, **caractérisé en ce que** le condenseur (26) est configuré pour la circulation d'un fluide réfrigérant destiné à échanger de la chaleur avec le fluide diélectrique (3).

9. Dispositif (1) selon la revendication 1, **caractérisé en ce que** le moyen de refroidissement (20) comprend en outre un échangeur de chaleur (24) permettant un échange de chaleur entre un fluide réfrigérant et un fluide de refroidissement, ledit condenseur (26) étant configuré pour la circulation dudit fluide de refroidissement en vue d'échanger de la chaleur avec le fluide diélectrique (3).

10. Dispositif (1) selon l'une des revendications précédentes, **caractérisé en ce qu'**il comprend un moyen de chauffage (28) dudit fluide diélectrique (3).

11. Pack-batterie (200) comprenant le dispositif (1) selon l'une des revendications précédentes ainsi qu'une pluralité de cellules (100) de batteries.

## Patentansprüche

1. Gerät (1) für die Temperaturkontrolle einer Batterie, die mindestens eine Energiespeicherzelle (100) beinhaltet, wobei das Gerät (1) einen Kreislauf (10) für ein dielektrisches Fluid beinhaltet, wobei der Kreislauf (10) Mittel (12) zum Berieseln der Oberfläche der Zelle (100) mit Hilfe des dielektrischen Fluids (3) beinhaltet, wobei das Fluid dazu bestimmt ist, auf der Oberfläche der Zellen mindestens teilweise zu verdampfen, wobei die Berieselungsmittel (12) Düsen (14) zum Versprühen des dielektrischen Fluids (3) in flüssiger Phase beinhalten, wobei das Gerät **dadurch gekennzeichnet ist, dass** es Folgendes beinhaltet: einen Behälter (16), der dazu konfiguriert ist, unterhalb der Zellen (100) angeordnet zu sein, und der dazu fähig ist, das dielektrische Fluid (3), das auf die Oberfläche der Batteriezellen (100) geschickt wird, in flüssiger Phase zu sammeln, sowie eine Pumpe (18), die dazu konfiguriert ist, das dielektrische Fluid (3) in dem Behälter (16) anzusaugen und unter Druck in den Kreislauf (10) für das dielektrische Fluid einzuspeisen,
und dass es ferner mindestens ein Mittel zum Kühlen (20) des dielektrischen Fluids (3) beinhaltet, wobei das Mittel einen Kondensator (26) beinhaltet, der dazu konfiguriert ist, das dielektrische Fluid (3) zu kondensieren, damit es von der Dampfphase in die flüssige Phase übergeht, und das Fluid (3) bis zum Behälter (16) rieseln zu lassen.

2. Gerät (1) nach Anspruch 1, **dadurch gekennzeichnet, dass** die Sprühdüsen (14) dazu konfiguriert sind, jeweils zwischen den Batteriezellen (100) platziert zu sein, um das dielektrische Fluid (3) auf seitliche Flächen der Zellen (100) zu spritzen.

3. Gerät (1) nach Anspruch 1, **dadurch gekennzeichnet, dass** die Sprühdüsen (14) dazu konfiguriert sind, oberhalb jeder Batteriezelle (100) platziert zu sein, um das dielektrische Fluid (3) auf obere Flächen der Zellen (100) zu spritzen.

4. Gerät (1) nach einem der Ansprüche 1 bis 3, **dadurch gekennzeichnet, dass** die Sprühdüsen (14) dazu konfiguriert sind, einen Strahl (5) eines dielektrischen Fluids (3) zu produzieren, wobei das Fluid (3) dazu bestimmt ist, auf der Oberfläche der Zellen (100) mindestens teilweise zu verdampfen.

5. Gerät (1) nach einem der Ansprüche 1 bis 3, **dadurch gekennzeichnet, dass** die Sprühdüsen (14) dazu konfiguriert sind, das dielektrische Fluid (3) in Form feiner Tropfen (7) zu zerstäuben, die dazu bestimmt sind, an der Oberfläche der Zellen (100) herabzufließen.

6. Gerät (1) nach Anspruch 1, **dadurch gekennzeichnet, dass** das Mittel zum Kühlen (20) des dielektrischen Fluids (3) einen Wärmeaustauscher (22) beinhaltet, der sich in dem Kreislauf (10) für das dielektrische Fluid befindet.

7. Gerät (1) nach Anspruch 1, **dadurch gekennzeichnet, dass** das Mittel zum Kühlen (20) des dielektrischen Fluids (3) einen Wärmeaustauscher (22) beinhaltet, der sich im Behälter (16) befindet.

8. Gerät (1) nach Anspruch 1, **dadurch gekennzeichnet, dass** der Kondensator (26) für die Zirkulation eines Kältefluids konfiguriert ist, das dazu bestimmt ist, Wärme mit dem dielektrischen Fluid (3) auszutauschen.

9. Gerät (1) nach Anspruch 1, **dadurch gekennzeichnet, dass** das Mittel zum Kühlen (20) ferner einen Wärmeaustauscher (24) beinhaltet, der einen Wärmeaustausch zwischen einem Kältefluid und einem Kühlfluid ermöglicht, wobei der Kondensator (26) für die Zirkulation des Kühlfluids konfiguriert ist, um Wärme mit dem dielektrischen Fluid (3) auszutauschen.

10. Gerät (1) nach einem der vorhergehenden Ansprüche, **dadurch gekennzeichnet, dass** es ein Mittel zum Erwärmen (28) des dielektrischen Fluids (3) beinhaltet.

11. Akkupack (200), das das Gerät (1) nach einem der vorhergehenden Ansprüche sowie eine Vielzahl von Batteriezellen (100) beinhaltet.

## Claims

1. Device (1) for regulating the temperature of a battery comprising at least one energy-storage cell (100), said device (1) comprising a dielectric-fluid circuit (10), said circuit (10) comprising means (12) for irrigating the surface of said cell (100) with said dielectric fluid (3), the fluid being intended to vaporize at least in part at the surface of the cells, wherein the irrigation means (12) comprise irrigation nozzles (14) that irrigate with the dielectric fluid (3) in the liquid phase,
the device being **characterized in that** it comprises a reservoir (16) configured to be positioned beneath the cells (100) and able to recover, in liquid phase, the dielectric fluid (3) applied to the surface of the battery cells (100), and a pump (18) configured to draw said dielectric fluid (3) in from the reservoir (16) and pressurize it in the dielectric-fluid circuit (10) and **in that** it further comprises at least one cooling means (20) for cooling the dielectric fluid (3), said means comprising a condenser (26) configured in such a way as to condense the dielectric fluid (3) to convert it from the vapour phase to the liquid phase and cause said fluid (3) to trickle back to the reservoir (16).

2. Device (1) according to Claim 1, **characterized in that** the irrigation nozzles (14) are configured to be placed between each battery cell (100) so as to spray the dielectric fluid (3) onto lateral faces of the cells (100) .

3. Device (1) according to Claim 1, **characterized in that** the irrigation nozzles (14) are configured to be placed above each battery cell (100) so as to spray the dielectric fluid (3) onto upper faces of the cells (100).

4. Device (1) according to one of Claims 1 to 3, **characterized in that** the irrigation nozzles (14) are configured in such a way as to produce a jet (5) of dielectric fluid (3), said fluid (3) being intended to vaporize at least in part at the surface of the cells (100) .

5. Device (1) according to one of Claims 1 to 3, **characterized in that** the irrigation nozzles (14) are configured in such a way as to atomize the dielectric fluid (3) to the form of fine droplets (7) intended to flow over the surface of the cells (100).

6. Device (1) according to Claim 1, **characterized in that** the cooling means (20) for cooling the dielectric fluid (3) comprises a heat exchanger (22) situated in the dielectric-fluid circuit (10).

7. Device (1) according to Claim 1, **characterized in that** the cooling means (20) for cooling the dielectric fluid (3) comprises a heat exchanger (22) situated in the reservoir (16).

8. Device (1) according to Claim 1, **characterized in that** the condenser (26) is configured for the circulation of a refrigerant intended to exchange heat with the dielectric fluid (3).

9. Device (1) according to Claim 1, **characterized in that** the cooling means (20) further comprises a heat exchanger (24) allowing an exchange of heat between a refrigerant and a coolant, said condenser (26) being configured for the circulation of said coolant with a view to exchanging heat with the dielectric fluid (3).

10. Device (1) according to one of the preceding claims, **characterized in that** it comprises a heating means (28) for heating said dielectric fluid (3).

11. Battery pack (200) comprising the device (1) according to one of the preceding claims as well as a plurality of battery cells (100).
